# EUROPEAN PATENT APPLICATION

(11) **EP 1 162 731 A2**
(43) Date of publication of application: **12.12.2001**
(21) Application number: 01113924.3
(22) Date of filing: 07.06.2001
(51) Int. Cl.: H03F 1/32

(54) **Microwave amplifying circuit, microwave amplifying device, and distortion compensation circuit**

(30) Priority: 08.06.2000 JP 2000172533
(71) Applicant: SUMITOMO ELECTRIC INDUSTRIES, LTD., Osaka-shi, Osaka (JP)
(72) Inventor: Kuwata, Nobuhiro, Yokohama Works, Sakae-ku, Yokohama-shi, Kanagawa (JP); Kotani, Kenji, c/o Yokohama Works, Sakae-ku, Yokohama-shi, Kanagawa (JP); Oooka, Mikiharu, c/o Yokohama Works, Sakae-ku, Yokohama-shi, Kanagawa (JP); Matsuzaki, Ken-ichiro, c/o Yokohama Works, Sakae-ku, Yokohama-shi, Kanagawa (JP); Sano, Hiroaki, c/o Yokohama Works, Sakae-ku, Yokohama-shi, Kanagawa (JP)
(74) Representative: Grünecker, Kinkeldey, Stockmair & Schwanhäusser Anwaltssozietät

(57) **Abstract**

A microwave amplifying circuit 1 has transistors 6, 8, and 10 and circuit sections 12, 14, 16, and 18. The circuit section 14 has one terminal electrically connected to a first current terminal of the transistor 6 and another terminal electrically connected to a control terminal of the transistor. The microwave amplifying circuit includes an impedance part 20a for supplying variable impedance between the terminals. The circuit section 16 has one terminal electrically connected to a first current terminal of the transistor 8 and another terminal electrically connected to a control terminal of the transistor 10. The circuit section 16 includes an impedance part 20b for providing variable impedance between the terminals.

## Description

### BACKGROUND OF THE INVENTION

### 1. Field of the Invention

The present invention relates to a microwave amplifying circuit, a microwave amplifying device, and a distortion compensation circuit.

### 2. Description of the Related Art

Publication 1 [Nikkei Electronics, April 19, 1999 (No. 741), pp. 142 through 142] and Publication 2 [Nikkei Electronics, July 12, 1999 (No. 747), pp. 158 through 159] are available as publications pertaining to a high-output amplifier for use with a portable device designed for a W-CDMA system.

Further, Publication 3 ("Technical Report" the Institute of Electronics, Information and Communication Engineers, Vol. 92, No. 93, pp. 31 through 36) and Publication 4 ("Technical Report" the Institute of Electronics, Information and Communication Engineers, Vol. 97, No. 93, pp. 37 through 42) are available as publications pertaining to a high-output amplifier for use in a base station of a mobile communications system.

Publication 3 describes a power amplifier of single amplifier stage in which two field-effect transistors are connected in parallel, thus achieving a desirable characteristic. Publication 4 describes a power amplifier of two amplifying stages in which two field-effect transistors are connected in series, thus achieving a desired characteristic.

The present inventor has reviewed such an amplifier. A base station of a mobile communications system is required to linearly amplify a signal without involvement of distortion, so as to prevent occurrence of crosstalk into adjacent channels. Further, an amplifier used in such a base station is also desired to produce a high output.

In a mobile computer, a high-output amplifier is desired to produce a high proportion of the output power of a radio wave signal to applied power; that is, is desired to have high power efficiency. Such a high power efficiency enables lengthening of a time in which the base station is operated by power. Accordingly, power consumption of the cell cite can be cut back. More specifically, a high output amplifier is desired to attain an improved distortion characteristic and improved efficiency.

In order to improve three-dimensional distortion by about 30 dB, a base station of W-CDMA system employs a distortion compensation circuit of feedforward type.

However, the distortion compensation circuit of feedforward type is desired to satisfy a rigorous gain variation. The reason for this is that a distortion compensation characteristic of a distortion compensation circuit of feedforward type greatly depends on variations in the gain of the distortion compensation circuit. For this reason, minimizing variations in the gain of the distortion compensation circuit is desired. Ideally, zero gain variation is desired.

Individual electronic components constituting a high-output amplifier; e.g., transistors, resistors, and capacitors, have their own frequency responses. A high-output amplifier eventually manufactured from these electronic components possesses a unique gain variation. Therefore, variations in the gain of a high-output amplifier must be adjusted on an individual basis.

### SUMMARY OF THE INVENTION

It is an object of the present invention to provide a microwave amplifying circuit, a microwave amplifying device, and a distortion compensation circuit, which enable adjustment of gain variation.

In relation to the high-output amplifier set forth, acquisition of a desired gain variation by combination of electronic components for diminishing gain variation is conceivable. On the other hand, in order to make a base station compact and less costly, a hybrid IC is used as high-output amplifier. In the hybrid IC, electronic components are integrated on a substrate whose sides have lengths on the order of tens of millimeters. If a hybrid IC is adopted, the number of components which are to be combined for adjusting gain variation is diminished. For this reason, adoption of a hybrid IC may lower a manufacturing yield of a base station.

To solve the problems, the present inventor has conducted studies involving trial and error. As a result, the following invention has been conceived.

A microwave amplifying circuit according to the present invention comprises a circuit input terminal; a circuit output terminal; first, second, and third transistors; and first, second, third, and fourth circuit sections.

The first circuit section has a first RF coupling part for effecting d.c. separation and a.c. coupling between the circuit input terminal and a control terminal of the first transistor, and a first impedance part for defining input impedance.

The second circuit section has a second RF coupling part for effecting d.c. separation and a.c. coupling between a first current terminal of the first transistor andacontrol terminal of the second transistor, a matching part for effecting matching between the first current terminal of the first transistor and the control terminal of the second transistor, and a second impedance part for supplying variable impedance between the first current terminal of the first transistor and the control terminal of the second transistor.

The third circuit section includes a third RF coupling part for effecting d.c. separation and a.c. coupling between a first current terminal of the second transistor and a control terminal of the third transistor, a matching part for effecting matching between the first current terminal of the second transistor and the control terminal of the third transistor, and a third impedance part for supplying variable impedance between the first current terminal of the second transistor and the control terminal of the third transistor.

The fourth circuit section includes a fourth RF part for effecting d.c. separation and a.c. coupling between the circuit output terminal and a first current terminal of the third transistor, and a fourth impedance part for defining output impedance.

There are provided at least three amplifying stages, and impedance parts for variable impedance between the amplifying stages. Gain variation can be adjusted by means of adjusting the variable impedance.

A microwave amplifying circuit comprises a circuit input terminal; acircuit output terminal; first, second, and third amplifying stages; and first and second capacitors. Each of the amplifying stages has a stage input terminal and a stage output terminal, amplifies a signal received by the stage input terminal, and supplies the amplified signal to the stage output terminal. The first capacitor is interposed between the stage output terminal of the first amplifying stage and the stage input terminal of the second amplifying stage, and enables adjustment of capacitance. The second capacitor is interposed between the stage output terminal of the second amplifying stage and the stage input terminal of the third amplifying stage, and enables adjustment of capacitance.

The first amplifying stage has an amplifying section including a first transistor, and a first circuit part which is interposed between the control terminal of the first transistor and the stage input terminal and which defines input impedance. The first amplifying stage receives a signal output from the circuit input terminal at the control terminal of the first transistor by way of the stage input terminal and supplies to the stage output terminal a signal output from the first current terminal of the first transistor.

The second amplifying stage has an amplifying section including a second transistor. The amplifying section receives a signal output from the stage input terminal at the control terminal of the second transistor and supplies to the stage output terminal a signal output from the first current terminal of the second transistor.

The third amplifying stage has an amplifying section including a third transistor, and a second circuit part which is interposed between the first current terminal of the third transistor and the stage output terminal and which defines output impedance. The third amplifying stage receives a signal output from the stage input terminal at the control terminal of the third transistor and, by way of the stage output terminal, supplies to the circuit output terminal a signal output from the first current terminal of the third transistor.

The first and second capacitors are interposed between the amplifying stages. By means of changing the capacitance of each of the first and second capacitors, gain variation can be changed without involvement of a change in circuit components.

The microwave amplifying circuit can be applied to a microwave amplifying device and a distortion compensation circuit, which will be described later.

A microwave amplifying device according to the present invention comprises a plurality of terminals; a circuit board having a microwave amplifying circuit mounted thereon; and an electromagnetic shield member covering the microwave amplifying circuit. In the microwave amplifying circuit, a circuit input terminal is connected to one of the plurality of terminals, and a circuit output terminal is connected to one of the plurality of terminals.

A distortion compensation circuit according to the present invention compensates for a distortion characteristic by means of a feedforward method. The distortion compensation circuit comprises a compensation circuit input terminal; a compensation circuit output terminal; first and second signal distribution parts; first and second signal coupling parts; first and second signal delay parts, and an equalizer. An input terminal of the first signal distribution part receives a signal output from the distortion compensation circuit. An output terminal of the first signal coupling part supplies a signal to the output terminal of the distortion compensation circuit. The distortion compensation circuit further comprises a preamplifier connected to the input terminal of the first signal distribution part.

The microwave amplifying circuit which has been described above or a microwave amplifying circuit which will be described later can be employed for each of the first and second amplifiers. The microwave amplifying circuit or a microwave amplifying circuit which will be described later can be employed for at least any one of the first and second amplifiers and the pre-amplifier.

Each of first and second signal distribution parts has an input terminal and two output terminals and distributes to the two output terminals a signal received by the input terminal. Each of first and second signal coupling parts has two input terminals and an output terminal, merges signals received by the two input terminals, and supplies the resultant signal to the output terminal. The first amplifier is connected to one of the output terminals of the first signal distribution part and is connected to the input terminal of the second signal distribution part. The first signal delay part is connected to one of the output terminals of the second signal distribution part and is connected to one of the input terminals of the second signal coupling part. The second signal delay part is connected to the remaining one of the output terminals of the first signal distribution part and is connected to one of the input terminals of the first signal coupling part. The second amplifier is connected to the output terminal of the first signal coupling part and is connected to the remaining input terminal of the second signal coupling part. The equalizer is interposed between the remaining output terminal of the second signal distribution part and the remaining input terminal of the first signal coupling part.

Each of the microwave amplifying circuit, the microwave amplifying device, and the distortion compensation circuit according to the present invention can have first, second, and third input bias parts and first, second, and third output bias parts.

The first input bias part has the function of imparting a bias to the control terminal of the first transistor. The second input bias part has the function of imparting a bias to the control terminal of the second transistor. The third input bias part has the function of imparting a bias to the control terminal of the third transistor.

The first output bias part has the function of imparting a bias to the first current terminal of the first transistor. The second output bias part has the function of imparting a bias to the first current terminal of the second transistor. The third output bias part has the function of imparting a bias to the first current terminal of the third transistor.

The bias parts can set a bias in accordance with each of the amplifying stages.

In each of the microwave amplifying circuit, the microwave amplifying device, and the distortion compensation circuit according to the present invention, when a capacitance of either the first or second capacitor is changed, a slope of a characteristic line; that is, (G1-G2)/ (f1-f2), can be changed. Here, in a coordinate system defined by an X-axis representing frequency and a Y-axis representing gain, the characteristic line is defined so as to pass through a point (f1, G1) defined by a frequency f1 and a gain G1 and a point (f2, G2) defined by a frequency f2 and a gain G2, the frequencies f1 and f2 differing from each other and being selected so as to be included in a frequency band to be employed.

### BRIEF DESCRIPTION OF THE DRAWINGS

Figs. 1A and 1B are block diagrams showing a microwave amplifying circuit according to an embodiment of the present invention;
Fig. 2 is a circuit diagram showing the microwave amplifying circuit according to the embodiment;
Fig. 3 is a gain characteristic chart pertaining to the microwave amplifying circuit according to the embodiment;
Fig. 4 is a gain characteristic chart pertaining to the microwave amplifying circuit according to the embodiment;
Figs. 5A and 5B are VSWR characteristic drawings pertaining to the microwave amplifying circuit according to the embodiment;
Figs. 6A and 6C are block diagrams showing an application of a microwave amplifying circuit;
Figs. 6B and 6D are drawings showing the relationship between gain and frequency appearing in each of the block diagrams shown in Figs. 6A and 6C;
Fig. 7A is a top view showing a microwave amplifying device;
Fig. 7B is a top view showing the microwave amplifying device while a shield plate is removed from the device;
Fig. 7C is a front view showing the microwave amplifying device;
Fig. 7D is a side view showing the microwave amplifying device; and
Fig. 8 is a block diagram showing a distortion compensation circuit.

### DETAILED DESCRIPTION OF THE INVENTION

Findings concerning the present invention can be readily understood from detailed descriptions provided below, by reference to the accompanying drawings. A microwave amplifying circuit, a microwave amplifying device, and a distortion compensation circuit according to the present invention will be described in detail by reference to the drawings. When possible, like elements are assigned like reference numerals, and their repeated explanations are omitted.

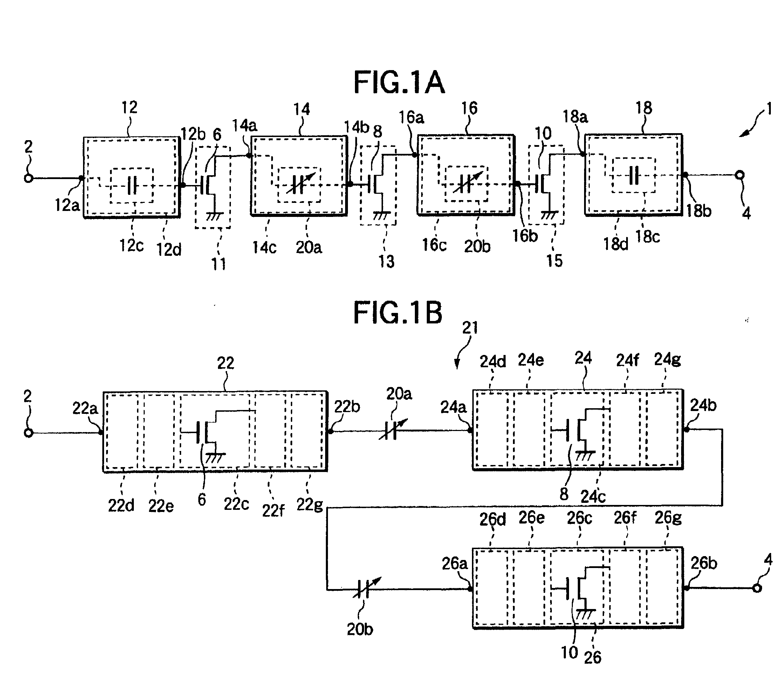

Fig. 1A shows a microwave amplifying circuit 1 according to an embodiment of the present invention.

The microwave amplifying circuit 1 is equipped with a circuit input terminal 2, a circuit output terminal 4, a first transistor 6, a second transistor 8, and a third transistor 10. Each of the first, second, and third transistors 6, 8, and 10 has a first current terminal, a second current terminal, and a control terminal. The following descriptions pertain to a case where the microwave amplifying circuit 1 includes Group III-V compound semiconductor transistors 6, 8, 10, which are applicable to a high-performance microwave amplifying circuit. In this case, the first current terminal corresponds to a drain; the second current terminal corresponds to a source; and the control terminal corresponds to a gate. The microwave amplifying circuit 1 has a first circuit section 12, a second circuit section 14, a third circuit section 16, and a fourth circuit section 18. The transistor 6 belongs to an amplifying section 11; the transistor 8 belongs to an amplifying section 13; and the transistor 10 belongs to an amplifying section 15.

The first circuit section 12 has an input terminal 12a for receiving a signal entered by way of the circuit input terminal 2, and an output terminal 12b for delivering the signal to the gate of the transistor 6. The first circuit section 12 is provided between the terminals 12a and 12b. Interposed between the input terminal 12a and the gate of the transistor 6 are a first RF coupling part 12c, e.g., a capacitor, which blocks flow of a d.c. voltage and which effects a.c. coupling, and a first impedance part 12d for defining input impedance.

The second circuit section 14 has an input terminal 14a and an output terminal 14b. The input terminal 14a is electrically connected to the drain of the transistor 6, and the output terminal 14b is electrically connected to the gate of the transistor 8. In the second circuit section 14, a second RF coupling part 20a, e.g., a capacitor, is interposed between the terminals 14a and 14b for blocking flow of a d.c. voltage. In order to provide variable impedance between the terminals 14a and 14b, the second RF coupling part 20a also acts as a second impedance part 20a, e.g., an impedance element. There can be provided between the terminals 14a and 14b a first matching part 14c for effecting at least either impedance matching or noise matching.

The third circuit section 16 has an input terminal 16a and an output terminal 16b. The input terminal 16a is electrically connected to the drain of the transistor 8, and the output terminal 16b is electrically connected to the gate of the transistor 10. A third RF coupling part 20b; e.g., an impedance element, is provided between the drain of the transistor 8 and the gate of the transistor 10 for blocking flow of a d.c. voltage and effecting a.c. coupling. In order to provide variable impedance between the terminals 16a and 16b, the RF coupling part 20b also acts as a third impedance part 20b. There can be provided between the terminals 16a and 16b a second matching part 16c for effecting at least either impedance matching or noise matching.

The fourth circuit section 18 has a fourth RF part 18c which is interposed between the circuit output terminal 4 and the drain of the transistor 10, blocks flow of a d.c. voltage, and effects a.c. coupling. Further, the fourth circuit section 18 has a fourth impedance part 18d for defining output impedance.

Fig. 1B shows a microwave amplifying circuit 21 according to the embodiment. The microwave amplifying circuit 21 has a circuit input terminal 2, a circuit output terminal 4, a first amplifying stage 22, a second amplifying stage 24, a third amplifying stage 26, a first capacitor 20a, and a second capacitor 20b. The first amplifying stage 22 has a stage input terminal 22a and a stage output terminal 22b. The second amplifying stage 24 has a stage input terminal 24a and a stage output terminal 24b. The third amplifying stage 26 has a stage input terminal 26a and a stage output terminal 26b. Each of the amplifying stages 22, 24, and 26 amplifies an input signal and outputs the signal after having amplified it.

The first capacitor 20a is interposed between the stage output terminal 22b of the first amplifying stage 22 and the stage input terminal 24a of the second amplifying stage 24. The capacitance of the first capacitor 20a is variable. The second capacitor 20b is interposed between the stage output 24b of the second amplifying stage 24 and the stage input terminal 26a of the third amplifying stage 26. The capacitance of the second capacitor 20b is variable.

The first amplifying stage 22 has an amplifying section 22c including a transistor 6 and an input circuit part 22d interposed between the gate of the transistor 6 and the stage input terminal 22a for specifying input impedance. In the first amplifying stage 22, the gate of the transistor 6 receives a signal entered by way of the circuit input terminal 2 by way of the stage input terminal 22a. Further, the signal is supplied to the stage output terminal 22b from the drain of the transistor 6. The first amplifying stage 22 further has a first input bias part 22e, a first output bias part 22f, and an output circuit part 22g. The first input bias part 22e has the function of imparting a bias to the gate of the transistor 6. The first output bias part 22f has the function of imparting a bias to the drain of the transistor 6. The output circuit part 22g is interposed between the stage output terminal 22b and the drain of the transistor 6. The output circuit part 22g has the function of defining an output impedance of the amplifying stage 22.

The second amplifying stage 24 has an amplifying section 24c including a transistor 8. In the second amplifying stage 24, the amplifying section 24c receives the signal entered by way of the stage input terminal 24a at the gate of the transistor 8 and outputs the signal from the drain of the transistor 8 to the stage output terminal 24b. The second amplifying stage 24 also has an input circuit part 24d, a second input bias part 24e, a second output bias part 24f, and an output circuit part 24g. The input circuit part 24d is interposed between the gate of the transistor 8 and the stage input terminal 24a and has the function of defining an input impedance of the second amplifying stage 24. The second input bias part 24e has the function of imparting a bias to the gate of the transistor 8. The second output bias part 24f has the function of imparting a bias to the drain of the transistor 8. The output circuit part 24g is interposed between the stage output terminal 24b and the drain of the transistor 8 and has the function of defining an output impedance of the second amplifying stage 24.

The third amplifying stage 26 has an amplifying section 26c including a transistor 10. The third amplifying stage 26 is interposed between the drain of the transistor 10 and the stage output terminal 26b. Further, the third amplifying stage 26 has an output circuit part 26g for defining an output impedance of the third amplifying stage 26. In the third amplifying stage 26, the gate of the transistor 10 receives a signal output from the stage input terminal 26a, and the signal output from the drain of the transistor 10 is supplied to the circuit output terminal 4 by way of the stage output terminal 26b. Further, the third amplifying stage 26 has an input circuit part 26d, a third input bias part 26e, and a third output bias part 26f. The input circuit part 26d is interposed between the gate of the transistor 10 and the stage input terminal 26a and has the function of defining an input impedance of the amplifying stage 26. The third input bias part 26e has the function of imparting a bias to the gate of the transistor 10. The third output bias part 26f has the function of imparting a bias to the drain of the transistor 10,

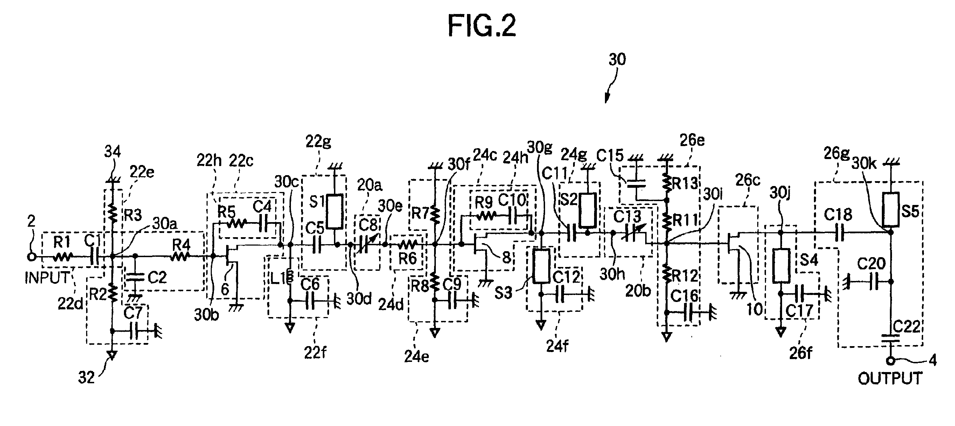

Fig. 2 shows a circuit diagram of a microwave amplifying circuit 30.

The amplifying section 22c can include a feedback part 22h in addition to the transistor 6. The feedback part 22h is interposed between the gate (i.e., a node 30b) and drain (i.e., a node 30c) of the transistor 6. A portion of an output signal is fed back to the input terminal of the amplifying section 22c, thus expanding a frequency range of this amplifying stage. The feedback part 22h includes a resistor R5 and a capacitor C4. The resistor R5 and the capacitor C4 are connected in series.

The input circuit part 22d is interposed between the input terminal 2 and the node 30b. The input circuit part 22d has a resistor R1, a capacitor Cl, and a resistor R4, which are connected in series. Further, the input circuit part 22d includes a capacitor C2 interposed between the node 30a and a first reference potential line 34. The capacitor C1 effects d.c. separation and a.c. coupling between the input terminal 2 and the node 30b. Provided that a frequency within an amplifying range of the microwave amplifying circuit 30 is set to ω, the value of the capacitor C1 is set such that 1/ωC becomes sufficiently smaller than an input impedance. In the amplifying range of the microwave amplifying circuit 30, the input circuit part 22d sets the input impedance of the microwave amplifying circuit 30 so as to assume a value of 50 Ω.

The input bias part 22e is provided so as to impart an appropriate d.c. bias current to the nodes 30a and 30b which are separated from the input terminal 2 in relation to d.c. components. The input bias part 22e has a resistor R3 interposed between the first reference potential line 34 and the node 30a; a resistor R2 interposed between the second reference potential line 32 and the node 30a; and a capacitor C7 interposed between the second reference potential line 32 and one end of the resistor R2. The resistors R2 and R3 are set so as to assume values sufficiently larger than the input impedance. The capacitor C7 develops a short circuit in a feeding point within an amplifying range of the microwave amplifying circuit 30, thereby lessening influence of the reference potential lines 32 and 34.

The output circuit part 22g is interposed between a node 30d and the node 30c, thereby defining an output impedance of the amplifying stage 22. The output circuit part 22g has a stub waveguide S1 interposed between the reference potential line 32 and the node 30d, and a capacitor C5 interposed between the nodes 30c and 30d.

An output bias part 22f is provided so as to impart an appropriate d.c. bias current to the node 30e. The output bias part 22f has an inductance L1 interposed between the second reference potential line 32 and the node 20c, and a capacitor C6 interposed between the second reference potential line 32 and one end of the inductance L1. The value of the inductance L1 is set such that ωL becomes sufficiently smaller than the impedance defined by the output circuit part 22g. The capacitor 6 also makes a short circuit in a feeding point, in the same manner as does the capacitor 7.

In addition to the transistor 8, the amplifying section 24c can include a feedback part 24h. The feedback part 24h is interposed between the gate (i.e., a node 30f) and drain (i.e., a node 30g) of the transistor 8 and feeds back a portion of an output signal to the input terminal of the amplifying section 24c, thus expanding a frequency range of this amplifying stage. The feedback part 24h includes a resistor R9 and a capacitor C10. The resistor R9 and the capacitor C10 are connected in series.

The input circuit part 24d has a resistor R6 interposed between the node 30e and the node 30f and defines an input impedance.

The input bias part 24e is provided for imparting an appropriate d.c. bias current to the node 30f which is separated from the node 30d in terms of d. c. components. The input bias part 24e has a resistor R7 interposed between the first reference potential line 34 and the node 30f; a resistor R8 interposed between the second reference potential line 32 and the node 30f; and a capacitor C9 interposed between the second reference potential line 32 and the resistor R2. The values of the resistors R7 and R8 are set so as to become sufficiently greater than the input impedance of the transistor 8 when viewed from the node 30f. The capacitor C9 also operates in the same manner as does the capacitor C7.

The output circuit part 24g is interposed between the nodes 30g and 30h and defines output impedance. The output circuit part 24g has a stub waveguide S2 interposed between the reference potential line 32 and the node 30h, and a capacitor C11 interposed between the node 30g and the node 30h.

An output bias part 24f is provided so as to impart an appropriate d.c. bias to the node 30g. The output bias part 24f has a stub waveguide S3 interposed between the second reference potential line 32 and the node 30c, and a capacitor C12 interposed between the second reference potential line 32 and one end of the stub waveguide S3. The capacitor C12 operates so as to make a short circuit in a feeding point, in the same manner as the capacitor C7.

The amplifying section 26c is formed from a transistor 10. The amplifying section 26c amplifies power in preference to expanding a frequency band. However, this does not signify that the feedback part is eliminated. The input circuit part 26d is omitted from the embodiment shown in Fig. 2, and the embodiment may include the input circuit part 26d.

The input bias part 26e is provided so as to impart an appropriate d.c. bias current to a node 30i separated from the node 30h in terms of d.c. components. The input bias part 26e has resistors R11 and R13 interposed between the first reference potential line 34 and the node 30f; a resistor R12 interposed between the second reference potential line 32 and the node 30i; a capacitor C9 interposed between the second reference potential line 32 and one end of the resistor R12; and a capacitor C15 connected to a node between the resistors R11 and R13. The resistors R11, R12, and R13 are set to values which are sufficiently larger than the input impedance of the transistor 10 when viewed from the node 30i. The capacitors C15 and C16 operate in the same manner as does the capacitor C7.

The output bias part 26f is provided so as to impart an appropriate d.c. bias to the node 30i. The output bias part 26f has a stub waveguide S4 interposed between the second reference potential line 32 and the node 30j, and a capacitor C17 interposed between the second reference potential line 32 and one end of the stub waveguide S4. The capacitor C17 operates so as to make a short circuit in a feeding point, in the same manner as the capacitor C7.

The output circuit part 26g is interposed between the node 30j and the circuit output terminal 4 and defines output impedance of the amplifying stage 26. The output circuit part 26g has a stub waveguide S4 interposedbetween the reference potential line 32 and a node 30k; a capacitor C18 interposed between the node 30j and the node 30k; a capacitor C20 interposed between the node 30k and the reference potential line 34; and a capacitor C22 interposed between the node 30k and the circuit output terminal 4. The capacitor C22 effects d.c. separation and a.c. coupling between the output terminal 4 and the node 30k. Provided that a frequency within an amplifying range of the microwave amplifying circuit 30 is set to ω, the value of the capacitor C22 is set such that 1/ωC becomes sufficiently smaller than an input impedance. Within the amplifying range of the microwave amplifying circuit 30, the output circuit part 26g sets output impedance of the microwave amplifying circuit 30 so as to assume a value of 50 Ω.

In the microwave amplifying circuit 30 shown in Fig. 2, a trimmer capacitor C8 is interposed between the node 30d and the node 30e. Further, a trimmer capacitor C13 is interposed between the node 30h and the node 30i . The trimmer capacitor C8 can change the extent of electrical coupling between the amplifying stages provided on respective sides of the capacitor C8. Similarly, the trimmer capacitor C13 can change the extent of electrical coupling between the amplifying stages provided on respective sides of the capacitor C13. Consequently, the extent of impedance matching in each of amplifying stages can be changed. Hence, gain variations between the amplifying stages of the microwave amplifying circuit can be adjusted. Consequently, variations in the gain of the microwave amplifying circuit can be adjusted.

The microwave amplifying circuit 30 is not limited to that described above and can be applied to an amplifying circuit of W-CDMA system. For a base station of W-CDMA system, a dynamic range of 60 MHz is employed, more preferably, a dynamic range of 100 MHz. In contrast with an amplifying range of 20 MHz employed in a related-art base station, an amplifier having a wider range is requested. The W-CDMA system requires a dynamic range of 20 MHz for one carrier wave. In terms of commonality of components for a base station, a dynamic range corresponding to three carrier waves is preferable.

In this application area, input matching and output matching must be sufficiently ensured. Matching is desired such that there is obtained a VSWR (voltage standing-wave ratio) of less than 2, and the VSWR is desired to approach a value of 1.

In this regard, the present inventor has conducted review. The result of review reveals a possibility that, when variation in the gain of the amplifier having the foregoing construction is changed intentionally, the input and output VSWRs will change correspondingly. Further, it has been found that a change of 0.3 or more in the input VSWR or in the output VSWR deteriorates matching between electronic components connected before and after the amplifying circuit. Loss of matching will deteriorate the gain of the amplifying circuit.

The present inventor has studied an amplifying circuit consisting of an input circuit stage, a first amplifying stage, a matching stage, and an output circuit stage. Through trial and error, the characteristic of the amplifying circuit was measured by providing a trimmer capacitor in the input circuit stage and in the output circuit stage. However, when the trimmer capacitor was provided in the input circuit stage and in the output circuit stage by trial, suppressing the VSWR to a value of 2 or less within an amplifying range of 60 MHz or more and suppressing the input and output VSWRs to a value of 0.3 or less while gain variations are changed ended in failure.

Further study has been conducted in an attempt to satisfy both a desire for gain variation and a desire for VSWR, as well as to broaden an amplifying range. As a result, the present inventor has conceived interposition of a trimmer capacitor between stages and addition of an amplifying stage. More specifically, at least three amplifying stages are employed, thereby ensuring a broad amplifying range. In addition, a trimmer capacitor is interposed between stages, thereby enabling control of a plurality of parameters at the time of adjustment of gain variations.

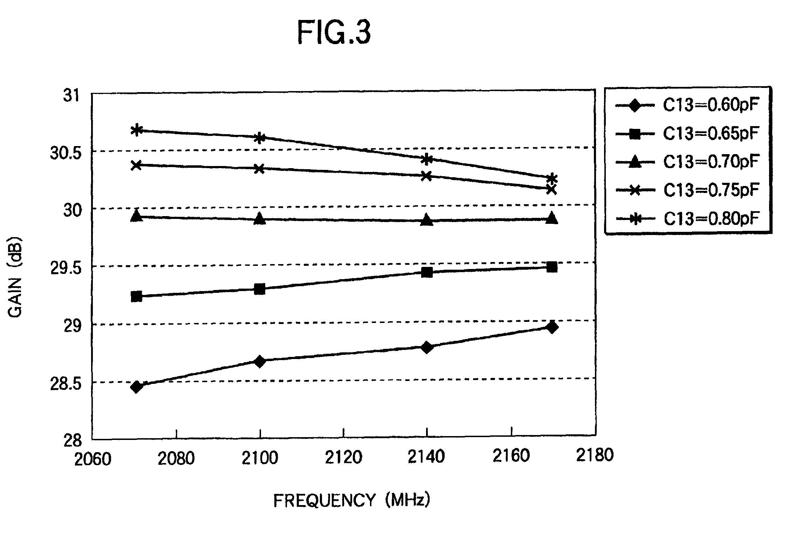

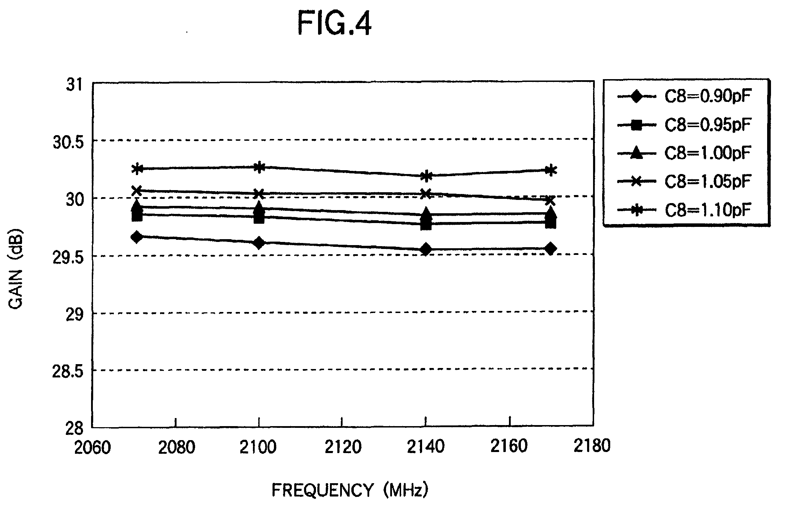

Fig. 3 shows frequency dependence of gain of the microwave amplifying circuit 30 shown in Fig. 2 when the capacitance of the capacitor C13 is changed among five different values. Fig. 4 shows frequency dependence of gain of the microwave amplifying circuit 30 shown in Fig. 2 when the capacitance of the capacitor C8 is changed among five different values. Measured frequencies range from 2070 MHz to 2170 MHz. Results shown in Fig. 3 reveal that, provided that the capacitor C8 has a capacitance of 1.00 pF, the slope of gain variation with respect to change in frequency can be adjusted by means of changing the capacitance C13. More specifically, as the capacitance of the capacitor C8 is changed, the slope of the characteristic curve changes monotonously. Particularly, the sign of the slope changes. According to the results shown in Fig. 4, provided that the capacitor C13 has a capacitance of 0.7 pF, the slope of gain variation with respect to change in frequency remains substantially unchanged even when the capacitance of the capacitor C8 is changed, and hence the overall gain of the amplifying circuit can be adjusted over the measured frequencies.

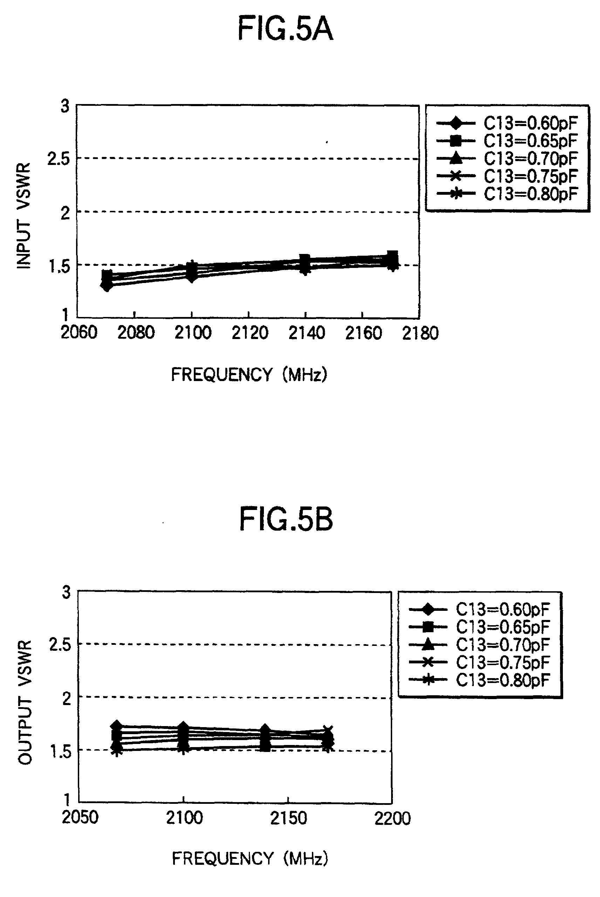

Figs. 5A and 5B show the frequency dependence of an input VSWR and that of an output VSWR obtained when the capacitance of the capacitor C13 is changed. Results of measurement reveal that the resultant VSWRs assume a value of 2 or less and a difference between the input and output VSWRs assumes a value of 0.3 or less.

Consequently, the frequency characteristic of gain of the microwave amplifying circuit can be changed without involvement of substantial changes in the input and output VSWRs.

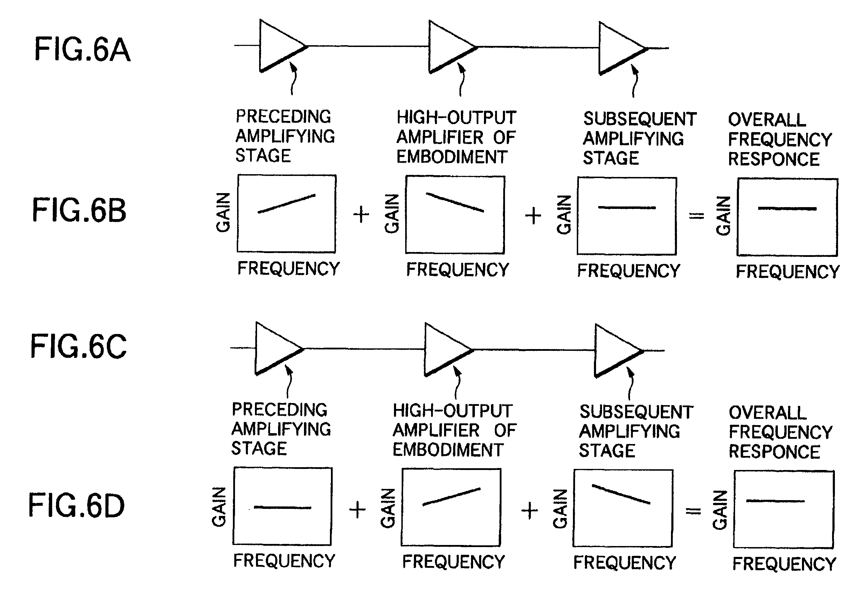

Figs. 6A and 6C show an amplifying device comprising three microwave amplifying circuits which are connected in series. Fig. 6B shows frequency characteristics of gains of amplifying circuits, and Fig. 6D shows frequency characteristics of synthesized gains of amplifying circuits.

Figs. 6A and 6B show that the gain characteristic of a preceding amplifier increases monotonously with regard to a frequency and that the gain characteristic of a subsequent amplifier remains substantially flat with regard to a frequency. Figs. 6C and 6D show that the gain characteristic of a preceding amplifier remains substantially flat with regard to a frequency and that the gain characteristic of a subsequent amplifier monotonously decreases with regard to a frequency. In such an amplifying device, so long as a microwave amplifying circuit according to the present embodiment is employed as an intermediate amplifying circuit, the overall gain characteristic of the amplifying device can be adjusted to a desired characteristic. In other words, even after assembly of an amplifying device, gain variations of the device can be adjusted so as to become flat with regard to changes in frequency.

In the above-described embodiment, there has been described an example of use of a trimmer capacitor as means for intentionally shifting impedance matching in order to change the frequency dependence of a gain. However, the present invention is not limited to such an example. For instance, the present invention may employ means for changing impedance, e.g., a resistance, an inductance, a voltage, or a current. A microwave applicable to a microwave amplifying circuit according to the present embodiment falls within the range of 300 MHz through 6.0 GHz.

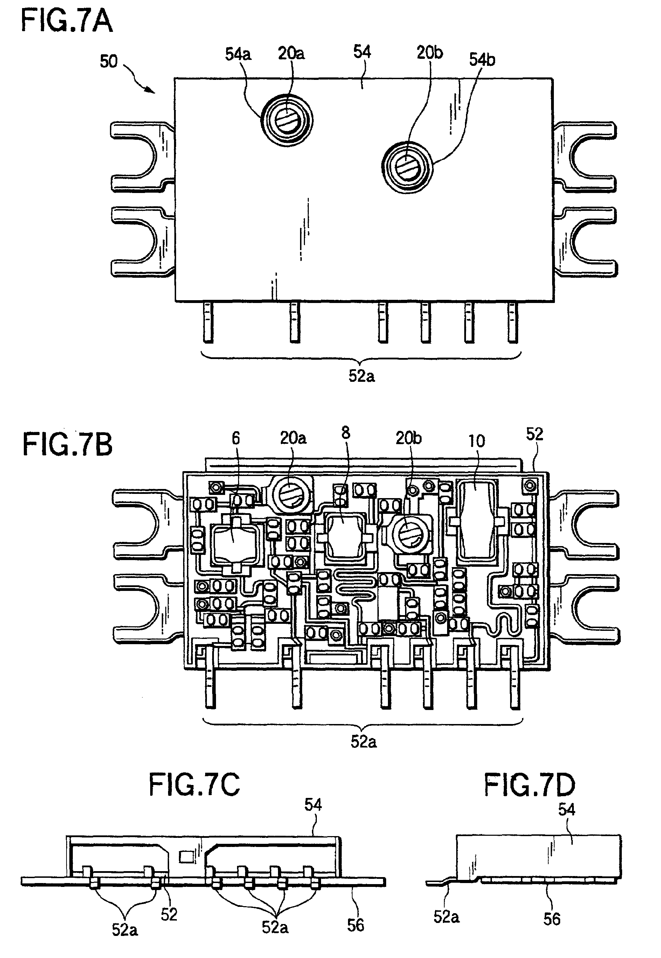

Figs. 7A, 7B, 7C, and 7D show examples in which the microwave amplifying circuit according to the above-described embodiments is applied to a microwave amplifying device.

A microwave amplifying device 50 according to the present embodiment has a plurality of terminals 52a, a circuit board 52 having the microwave amplifying circuit 30 mounted thereon, and an electromagnetic shielding member 54, e.g., a shieldplate, for covering the microwave amplifying circuit 30. In the microwave amplifying device 50, a circuit input terminal of the microwave amplifying circuit 30 is connected to any one of the plurality of terminals 52a of the substrate 52 . Acircuit output terminal of the microwave amplifying circuit 30 is connected to any one of the plurality of terminals 52a of the substrate 52.

The substrate 52 can be constituted of a printed wiring board having a superior high-frequency response, such as an aluminum substrate or a PPO substrate. Electronic components constituting the microwave amplifying circuit 30 shown in Fig. 2 are mounted on the substrate 52. By way of illustration, the transistors 6, 8, 10 and trimmer capacitors 20a and 20b are provided on the substrate 52. The back side of the circuit board 52 is supported by a conductive plate 56. The conductive plate 56 is connected to a ground potential line for shielding purpose. Projections are provided on the conductive plate 56 for fastening purposes. In the embodiment, projections extend along one side of the wiring board 52 having terminals provided thereon.

Through holes 54a and 54b are formed in the shield plate 54 so as to match the positions of the trimmer capacitors 20a and 20b. Through use of an adjustment jig, the capacitance of each of the trimmer capacitors 20a and 20b is changed by way of the through holes 54a and 54b, thus adjusting the characteristic of the microwave amplifying device 50. The adjustment is performed within a predetermined range of adjustment and without involvement of changes in electronic components. The shield plate 54 is connected to a ground potential line by way of a conductive layer of the substrate 52.

The present inventor has worried about an increase in radiation noise, which would otherwise result from forming through holes in the shield plate 54. However, as a result of trial and error, the present inventor has found that radiation noise can be suppressed to such an extent that substantially no influence arises, if a through hole is formed so as to assume a convex geometry. The geometry of an adjustment hole can be changed to, e.g., a circular geometry, a substantially circular geometry, an oval geometry, or a substantially oval geometry, as alternatives to the convex geometry. In the present embodiment, through holes can be formed readily, and circular through holes are adopted. In an application field in which a high level of resistance to noise is required, through holes can be sealed with a conductive cover member; e.g., a metal cap.

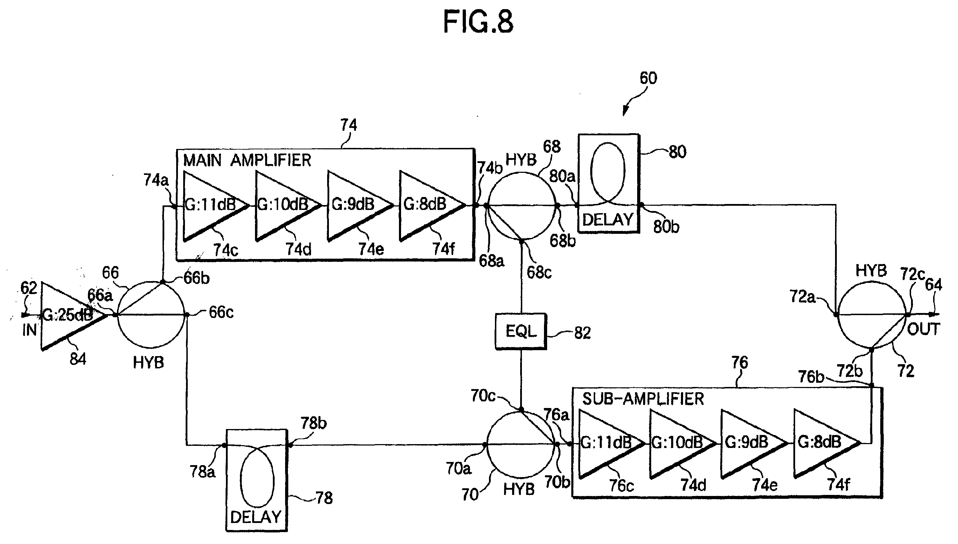

Fig. 8 shows a distortion compensation circuit. A distortion compensation circuit 60 compensates for a distortion characteristic by means of a feedforward method. The distortion compensation circuit 60 comprises a distortion compensation circuit input terminal 62; a distortion compensation circuit output terminal 64; first and second signal distribution parts 66 and 68; first and second signal coupling parts 70 and 72; a main amplifier 74 and a sub-amplifier 76, first and second signal delay parts 78 and 80, and an equalizer 82. In addition to the distortion compensation section, the distortion compensation circuit 60 can further include a preamplifier 84 connected to an input terminal 66a of the signal distribution part 66.

Although not limited to the following examples, the first and second signal distribution parts 66 and 68 may be embodied in, e.g., a 3-dB distributor or a directional coupler. Although not limited to the following examples, the first and second signal coupling parts 70 and 72 may be embodied in, e.g., a directional coupler. Although not limited to the following examples, the first and second signal delay parts 78 and 80 may be embodied in a delay circuit consisting of, e.g., a coaxial cable or an inductor. The first signal delay part 78 delays a signal in accordance with the amount of delay in the amplifier 74 connected in shunt with the first signal delay part 78. The second signal delay part 80 delays a signal in accordance with the amount of delay in the amplifier 76 connected in shunt with the second signal delay part 80. The equalizer 82 is provided for adjusting a signal level amplified by the main amplifier 74 to a certain level before the signal enters the sub-amplifier 76 and is embodied in a variable attenuator or a gain-variable amplifier.

The microwave amplifying circuit that has already been described can be used for at least any one of the main amplifier 74, the sub-amplifier 76, and the preamplifier 84, If the microwave amplifying circuit is applied to the preamplifier 84, a signal which is to enter a distortion compensation section provided in the distortion compensation circuit 60 can be amplified with less distortion. If the microwave amplifying circuit is applied to the main amplifier 74 and the sub-amplifier 76, each of the main and sub amplifiers 74 and 76 can achieve less distortion.

The following description relates to a case where the above-described examples are used for the respective means. However, the present invention is not limited to these examples. The distortion compensation section has two signal channels. The distributor 66 divides a received signal into two channels. After having been processed, the signals output by way of the two channels are combined together by means of the coupler 72.

In the distortion compensation section, an input terminal 66a of the distributor 66 receives a signal output from the input terminal 62 of the distortion compensation circuit 60. One output terminal 66b of the distributor 66 supplies a signal to an input terminal 74a of the main amplifier 74. An output terminal 74b of the main amplifier 74 supplies a signal to the input terminal 68a of the distributor 68. One output terminal 68b of the distributor 6B supplies a signal to an input terminal 80a of the delay circuit 80. An output terminal 80b of the delay circuit 80 supplies a signal to one input terminal 72a of the coupler 72.

In the distortion section, another output terminal 66c of the distributor 66 supplies a signal to an input terminal 78a of the delay circuit 78. An output terminal 78b of the delay circuit 78 supplies a signal to one input terminal 70a of the coupler 70. An output terminal 70b of the coupler 70 supplies a signal to an input terminal 76a of the sub-amplifier 76. An output terminal 76b of the sub-amplifier 76 supplies a signal to another input terminal 72b of the coupler 72. An output terminal 72c of the coupler 72 supplies the signal that has been subjected to distortion compensation to the output terminal 64 of the distortion compensation circuit 60. The equalizer 82 is interposed between another output terminal 68c of the distributor 68 and another input terminal 70c of the coupler 70.

The main amplifier 74 in Fig. 8 has one or a plurality of amplifying circuits and four amplifying circuits 74c through 74f. The sub-amplifier 76 has one or a plurality of amplifying circuits, for example, in Fig. 8, has four amplifying circuits 76c through 76f. The signal which has been amplified by the main amplifier 74 is merged with the signal delayed by the delay circuit 78, by way of the distributor 68, the equalizer 82, and the coupler 70. Through use of the thus-merged signal, distortion in the input signal is detected. The thus-detected distortion is amplified and inverted in phase by the sub-amplifier 76. The signal that has been amplified by the main amplifier 74 is delayed by the delay circuit 80. Thus, signals which have been produced in two channels are merged by the coupler 72, thereby producing a distortion-free signal.

The distortion compensation circuit of feedforward type is required to satisfy a requirement that the frequency characteristic of gain of the main amplifier 74 and the frequency characteristic of gain of the sub-amplifier 76 are substantially identical and a requirement that gain variations are substantially 0 dB.

As has been described in detail, each of the microwave amplifying circuit, the microwave amplifying device, and the distortion compensation circuit according to the present invention is provided with an amplifying stage consisting of at least three stages and impedance parts for supplying variable impedance between amplifying stages. By means of adjusting the variable impedance, gain variations are adjusted.

Consequently, there are provided a microwave amplifying circuit, a microwave amplifying device, and a distortion compensation circuit, which enable adjustment of gain variations.

## Claims

1. A microwave amplifying circuit comprising:
a circuit input terminal;
a circuit output terminal;
first, second, and third amplifying stages, each of which has a stage input terminal and a stage output terminal, amplifies a signal received by the stage input terminal, and supplies the amplified signal to the stage output terminal;
a first capacitor which is interposed between the stage output terminal of the first amplifying stage and the stage input terminal of the second amplifying stage and which enables adjustment of capacitance; and
a second capacitor which is interposed between the stage output terminal of the second amplifying stage and the stage input terminal of the third amplifying stage and which enables adjustment of capacitance,
wherein the first amplifying stage has an amplifying section including a first transistor, the first transistor having first and second current terminals and a control terminal, and a first circuit part which is interposed between the control terminal of the first transistor and the stage input terminal and which defines input impedance, in which the first amplifying stage receives a signal output from the circuit input terminal at the control terminal of the first transistor by way of the stage input terminal and supplies to the stage output terminal a signal output from the first current terminal of the first transistor;
the second amplifying stage has an amplifying section including a second transistor, the second transistor having first and second current terminals and a control terminal, in which the amplifying section receives a signal output from the stage input terminal at the control terminal of the second transistor and supplies to the stage output terminal a signal output from the first current terminal of the second transistor; and
the third amplifying stage has an amplifying section including a third transistor, the third transistor having first and second current terminals and a control terminal, and a second circuit part which is interposed between the first current terminal of the third transistor and the stage output terminal and which defines output impedance, in which the amplifying section receives a signal output from the stage input terminal at the control terminal of the third transistor and, by way of the stage output terminal, supplies to the circuit output terminal a signal output from the first current terminal of the third transistor.

2. The microwave amplifying circuit according to claim 1, further comprising:
a first input bias part for imparting a bias to the control terminal of the first transistor;
a first output bias part for imparting bias to the first current terminal of the first transistor;
a second input bias part for imparting a bias to the control terminal of the second transistor;
a second output bias part for imparting bias to the first current terminal of the second transistor;
a third input bias part for imparting a bias to the control terminal of the third transistor; and
a third output bias part for imparting bias to the first current terminal of the third transistor.

3. The microwave amplifying circuit according to claim 1, wherein each of the first, second, and third transistors corresponds to a group-III compound semiconductor transistor.

4. The microwave amplifying circuit according to claim 1, wherein, in connection with a straight line which is present in a coordinate system defined by an X-axis representing frequency and a Y-axis representing gain and which passes through a point (f1, G1) defined by a frequency f1 and a gain G1 and apoint (f2, G2) defined by a frequency f2 and a gain G2, the frequencies f1 and f2 differing from each other and being selected so as to be included in a frequency band to be employed, when a capacitance of either the first or second capacitor is changed, a slope of the straight line; that is, (G1-G2)/(f1-f2), can be changed.

5. A microwave amplifying device comprising:
a plurality of terminals;
a circuit board having a microwave amplifying circuit mounted thereon; and
an electromagnetic shield member covering the microwave amplifying circuit, the microwave amplifying circuit having:
a circuit input terminal connected to one of the plurality of terminals;
a circuit output terminal connected to one of the plurality of terminals;
first, second, and third amplifying stages interposed between the circuit input terminal and the circuit output terminal, each of which has a stage input terminal and a stage output terminal;
a first capacitor which is interposed between the stage output terminal of the first amplifying stage and the stage input terminal of the second amplifying stage and which enables adjustment of capacitance; and
a second capacitor which is interposed between the stage output terminal of the second amplifying stage and the stage input terminal of the third amplifying stage and which enables adjustment of capacitance,
wherein the first amplifying stage has an amplifying section including a first transistor, the first transistor having first and second current terminals and a control terminal, and a first circuit part which is interposed between the control terminal of the first transistor and the stage input terminal and which defines input impedance, in which the first amplifying stage receives a signal output from the circuit input terminal at the control terminal of the first transistor and supplies to the stage output terminal a signal output from the first current terminal of the first transistor;
the second amplifying stage has an amplifying section including a second transistor, the second transistor having first and second current terminals and a control terminal, in which the amplifying section receives a signal output from the stage input terminal at the control terminal of the second transistor and supplies to the stage output terminal a signal output from the first current terminal of the second transistor; and
the third amplifying stage has an amplifying section including a third transistor, the third transistor having first and second current terminals and a control terminal, and a second circuit part which is interposed between the first current terminal of the third transistor and the stage output terminal and which defines output impedance, in which the amplifying section receives a signal output from the stage input terminal at the control terminal of the third transistor and supplies to the circuit output terminal a signal output from the first current terminal of the third transistor.

6. The microwave amplifying device according to claim 5, wherein the electromagnetic shield member has a plurality of holes for adjustment purposes which are provided so as to match the first and second capacitors provided on the substrate.

7. The microwave amplifying device according to claim 5, wherein each of the first and second capacitors includes a trimmer capacitor.

8. A distortion compensation circuit for compensating for a distortion characteristic by means of a feedforward method, comprising:
a compensation circuit input terminal;
a compensation circuit output terminal;
first and second signal distribution parts, each of which has an input terminal and two output terminals and which distributes to the two output terminals a signal received by the input terminal;
first and second signal coupling parts, each of which has two input terminals and an output terminal and which merges signals received by the two input terminals and supplies the resultant signal to the output terminal;
a first amplifier which is connected to one of the output terminals of the first signal distribution part and is connected to the input terminal of the second signal distribution part;
a first signal delay part which is connected to one of the output terminals of the second signal distribution part and is connected to one of the input terminals of the second signal coupling part;
a second signal delay part which is connected to the other of the output terminals of the first signal distribution part and is connected to one of the input terminals of the first signal coupling part;
a second amplifier which is connected to the output terminal of the first signal coupling part and is connected to the other of the input terminals of the second signal coupling part; and
an equalizer interposed between the other of the output terminals of the second signal distribution part and the other of the input terminals of the first signal coupling part,
wherein the input terminal of the first signal distribution part receives a signal output from the compensation circuit input terminal; the output terminal of the first signal coupling part supplies a signal to the compensation circuit output terminal; and each of the first and second amplifiers includes the microwave amplifying circuit described in claim 1.

9. The distortion compensation circuit according to claim 8, further comprising a preamplifier connected to an input terminal of the first signal distortion part, and the preamplifier has the microwave amplifying circuit defined in claim 1.

10. The distortion compensation circuit according to claim 8, further comprising a preamplifier connected to an input terminal of the first signal distortion part,
wherein the compensation circuit input terminal receives a signal output from the preamplifier.
